# EUROPEAN PATENT APPLICATION

(11) **EP 2 661 164 A2**
(43) Date of publication of application: **06.11.2013**
(21) Application number: 11789253.9
(22) Date of filing: 14.06.2011
(51) Int. Cl.: H05K 7/20

(54) **DEVICE WITH HEAT INSULATION STRUCTURE**

(71) Applicant: Huawei Device Co., Ltd., Shenzhen, Guangdong 518129 (CN)
(72) Inventor: ZOU, Jie, Shenzhen Guangdong 518129 (CN); ZHOU, Liechun, Shenzhen Guangdong 518129 (CN); WU, Xijie, Shenzhen Guangdong 518129 (CN); YANG, Jun, Shenzhen Guangdong 518129 (CN)
(74) Representative: Pfenning, Meinig & Partner GbR
(86) International application number: PCT/CN2011/075708
(87) International publication number: WO 2011/150874

(57) **Abstract**

Embodiments of the present invention provide an apparatus with a heat insulation structure, where the apparatus includes an object to be heat-insulated (10) and also includes a heat insulation closed layer (20), disposed between the object to be heat-insulated (10) and a heat source (30). The heat insulation structure adopted in the present invention specifically is a heat insulation closed layer (20), where the heat insulation closed layer (20) performs heat insulation protection through a closed space between the object to be heat-insulated (10) and the heat source (30), rather than performing heat insulation mainly through a physical material with a small heat conduction coefficient. By performing heat insulation through the closed space, heat conducted through direct contact is reduced, and the closed space can effectively decrease heat transmission in forms of heat convection and heat radiation, solving a problem that heat is transferred from the heat source to the object to be heat-insulated, improving a heat insulation effect and lowering the temperature of a work environment of the object to be heat-insulated.

## Description

### FIELD OF THE INVENTION

Embodiments of the present invention relate to heat dissipation technologies, and in particular, to an apparatus with a heat insulation structure.

### BACKGROUND OF THE INVENTION

With the fast development of electronic technologies, the high frequency and high speed of an electronic component and the densification and miniaturization of an integrated circuit make the gross power of and the quantity of heat generated by the electronic component increase greatly, so the density of heat flows of a certain area or a certain single-point in a system is quite high, and a cooling problem of the electronic component becomes prominent increasingly.

The problem of high density of heat flows has great influence on a temperature-sensitive component or temperature-sensitive part, and direct influence is that, reliability of the temperature-sensitive component will decrease by 5% when the temperature of the temperature-sensitive component increases by 1°C above a level of 70-80°C, and at the same time, the life span of the temperature-sensitive component will be shortened as the temperature increases. For example, temperature has very great influence on the life span of a dry battery, and specific experimental data shows that the life span of the dry cell is shortened by 10% when the temperature increases by 5°C. Therefore, during research and development of an electronic product, a good heat dissipation manner needs to be considered fully, and meanwhile a heat insulation protection measure of the temperature-sensitive component also needs to be considered, and in this way, the reliability of the product and the life span of the product can be ensured.

A heat insulation protection measure of a heat-sensitive part adopted in the prior art is that, a heat insulation carrier is disposed outside the heat-sensitive part, serving both a function of fixing and installation and a heat insulation function. The heat insulation carrier is generally made of a material with a small heat conduction coefficient, such as a plastic material with a heat conduction coefficient of about 0.3 watt per meter kelvin (W/m-K), so as to insulate heat emitted by a heat source from the heat-sensitive part, thereby decreasing the temperature of a work environment of the heat-sensitive part.

However, in a research process of implementing the present invention, the inventors find that the existing heat insulation solution has the following disadvantages: The existing heat insulation solution has a certain effect on the heat insulation of the temperature-sensitive part, but the heat source still has great influence on the temperature-sensitive component; the heat source may transfer heat to the heat-sensitive part through heat radiation and heat conduction, causing that the heat-sensitive part works in a high-temperature environment, which influences the life span and the reliability of the heat-sensitive part.

### SUMMARY OF THE INVENTION

The present invention provides an apparatus with a heat insulation structure, so as to improve heat insulation effects on an object to be heat-insulated in the apparatus.

An embodiment of the present invention provides an apparatus with a heat insulation structure, which includes an object to be heat-insulated and further includes:
a heat insulation closed layer, disposed between the object to be heat-insulated and a heat source.

In the apparatus with a heat insulation structure provided by the embodiment of the present invention, the adopted heat insulation structure specifically is a heat insulation closed layer, where the heat insulation closed layer performs heat insulation protection through a closed space between the object to be heat-insulated and the heat source, rather than performing heat insulation mainly through a physical material with a small heat conduction coefficient. By performing heat insulation through the closed space, heat conducted through direct contact is reduced, and the closed space can effectively decrease heat transmission in forms of heat convection and heat radiation, solving a problem that heat is transferred from the heat source to the object to be heat-insulated, improving a heat insulation effect and lowering the temperature of a work environment of the object to be heat-insulated.

### BRIEF DESCRIPTION OF THE DRAWINGS

FIG. 1 is a schematic structural diagram of an apparatus with a heat insulation structure according to Embodiment 1 of the present invention; and
FIG. 2 is a schematic structural diagram of an apparatus with a heat insulation structure according to Embodiment 2 of the present invention.

### DETAILED DESCRIPTION OF THE EMBODIMENTS

To make the objectives, technical solutions, and advantages of the embodiments of the present invention more comprehensible, the following clearly and completely describes the technical solutions in the embodiments of the present invention with reference to the accompanying drawings in the embodiments of the present invention. Apparently, the described embodiments are merely part rather than all of the embodiments of the present invention. All other embodiments obtained by persons of ordinary skill in the art based on the embodiments of the present invention without creative efforts shall fall within the protection scope of the present invention.

### Embodiment 1

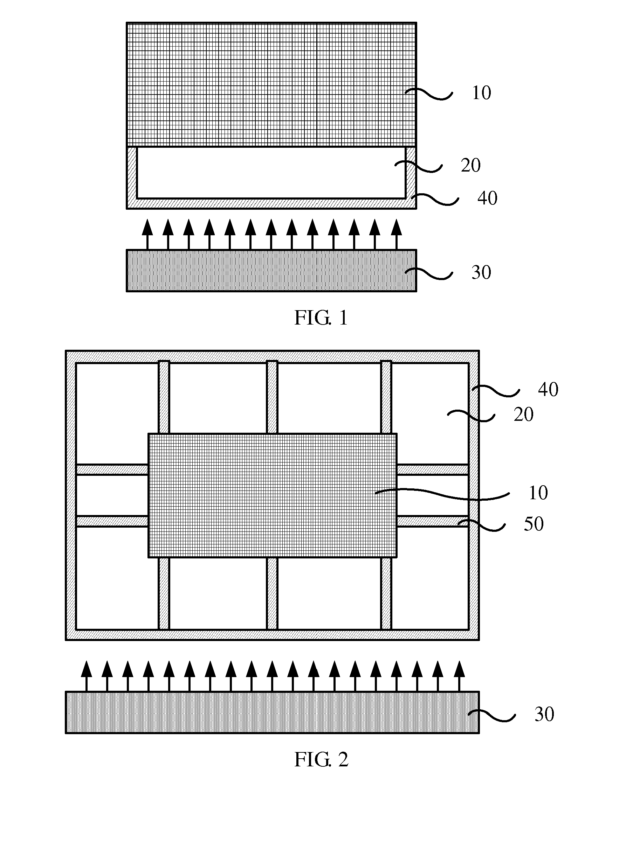

FIG. 1 is a schematic structural diagram of an apparatus with a heat insulation structure according to Embodiment 1 of the present invention. The apparatus with a heat insulation structure may be any apparatus including an object to be heat-insulated 10, which typically may be an electronic component and the like. The object to be heat-insulated 10 may be any component that needs protection of the heat insulation structure, which typically may be a temperature-sensitive component, for example, one or a combination of some of the following: a battery, a temperature controlling unit, an electrolytic capacitor, a liquid crystal display (LCD), an optical module, a camera module and a crystal.

In this embodiment, the apparatus with a heat insulation structure further includes a heat insulation closed layer 20, disposed between the object to be heat-insulated 10 and a heat source 30. Here, the heat source 30 refers to any heat source which emits heat and has influence on the environment temperature of the object to be heat-insulated 10, and may be a heat source 30 integrated into the apparatus, and may also be a heat source 30 which is close to a location where the apparatus is located.

The heat insulation structure adopted in the apparatus in this embodiment specifically is a heat insulation closed layer, where the heat insulation closed layer performs heat insulation protection through a closed space between the object to be heat-insulated and the heat source, rather than performing heat insulation mainly through a physical material with a small heat conduction coefficient. By performing heat insulation through the closed space, heat conducted through direct contact is reduced, and the closed space can effectively decrease heat transmission in forms of heat convection and heat radiation, solving a problem that heat is transferred from a high-temperature object or the heat source to the object to be heat-insulated, such as the heat-sensitive component or heat-sensitive part, lowering the temperature of a work environment of the object to be heat-insulated, lowering a reliability risk of the heat-sensitive component or the heat-sensitive part, and avoiding influence of high temperature on the life span of the heat-sensitive component or the heat-sensitive part.

Preferably, the heat insulation closed layer is filled with air, or the heat insulation closed layer is disposed as a vacuum. The air also is a poor heat conductor. In a closed status, a heat conduction system of the air is 0.023 W/m·k, which is one tenth of the heat conduction system of plastics. When an air heat insulation closed layer is adopted, by using a heat property that the heat conduction coefficient of closed air is small, a generated closed air layer can prevent the heat source such as the high-temperature component or the high-temperature object from having influence of temperature rise of the object to be heat-insulated such as the heat-sensitive component or the temperature-controlled part.

In this embodiment, the heat insulation closed layer 20 specifically is formed between an external wall of the object to be heat-insulated 10 and an internal wall of a heat insulation shell 40.

The heat insulation closed layer is not limited to being disposed adjacent to the object to be heat-insulated, as long as it is formed between the heat source and the object to be heat-insulated and can serve a function of preventing heat radiation and heat transmission. In this embodiment, preferably the external wall of the object to be heat-insulated is directly adjacent to the heat insulation closed layer and is used as one of surrounding walls that form the heat insulation closed layer, thereby decreasing heat transmission through heat convection on a surface of the object to be heat-insulated.

In this embodiment, as for a location relationship relative to the object to be heat-insulated 10, the heat insulation closed layer 20 is disposed on the side of the object to be heat-insulated 10 facing the heat source 30. Definitely, it is not limited to being disposed on one side, and the heat insulation closed layer 20 may be disposed on the external side of a part of the surface of the object to be heat-insulated 10 which faces the heat source 30 or needs to be insulated from heat.

In a practical application, the object to be heat-insulated may be disposed on a carrying base, for example, disposed on a printed circuit board. Then the external side of the object to be heat-insulated is covered by the heat insulation shell, forming the heat insulation closed layer between the heat insulation shell and the object to be heat-insulated, so as to insulate heat emitted by the heat source in forms of heat radiation, heat conduction and heat convection.

### Embodiment 2

FIG. 2 is a schematic structural diagram of an apparatus with a heat insulation structure according to Embodiment 2 of the present invention. A difference between this embodiment and Embodiment 1 lies in that a relative location relationship between a heat insulation closed layer 20 and an object to be heat-insulated 10 is optimized. In this embodiment, a support 50 is connected for fixing between an internal wall of a heat insulation shell 40 and an external wall of the object to be heat-insulated 10.

The shape of the support 50 is not limited, and preferably is a point-contact connection with a small area or is a columnar upholder. The support 50 may be integrated with the heat insulation shell 40, or may also be an independent connection component. Materials of the support 50 and the heat insulation shell 40 are both preferably made of materials with a small heat conduction coefficient.

Advantages of the technical solution in this embodiment are that, on one hand, connection intensity between the heat insulation shell 40 and the object to be heat-insulated 10 may be strengthened, and the support 50 can decrease the heat conduction through small area contact based on a principle that thermal energy of heat conduction is in a direct proportion to contact area; on the other hand, the object to be heat-insulated 10 can be further disposed inside the heat insulation shell 40, and the periphery of the object to be heat-insulated 10 and the heat insulation shell 40 are fixed through the support 50. In this technical solution, the entire object to be heat-insulated 10 can be disposed to be surrounded by the closed heat insulation layer, and is fixed only through the support 50. The advantage of this technical solution is that, contact area between the object to be heat-insulated 10 and a connected object is effectively decreased, thereby reducing influence of the heat conduction on temperature rise. The support 50 is adopted in the heat insulation closed layer 20 for fixing, which can effectively reduce influence of a high-temperature component or high-temperature object on the temperature of a heat-sensitive component or special controlled component, and reduce a heat risk thereof, thereby lengthening the life span of the entire equipment.

Preferably, contact area between the surface of one external wall of the object to be heat-insulated 10 and the connected support 50 is smaller than 50% of the area of the surface of the external wall, which can take into account both a fixing function and a function of reducing heat conduction. For the object to be heat-insulated 10 typically of a cubic shape, contact area between one single face of the cube and the connected support 50 is smaller than 50% of the area of this face.

Finally, it should be noted that the foregoing embodiments are merely used for describing the technical solutions of the present invention rather than limiting the present invention. Although the present invention is described in detail with reference to the foregoing embodiments, persons of ordinary skill in the art should understand that they may still make modifications to the technical solution described in the foregoing embodiments or make equivalent replacements to some technical features thereof; and such modifications or replacements do not make essence of corresponding technical solutions depart from the spirit and scope of the technical solution of the embodiments of the present invention.

## Claims

1. An apparatus with a heat insulation structure, comprising an object to be heat-insulated, and further comprising:
a heat insulation closed layer, disposed between the object to be heat-insulated and a heat source.

2. The apparatus with a heat insulation structure according to claim 1, wherein
the heat insulation closed layer is formed between an external wall of the object to be heat-insulated and an internal wall of a heat insulation shell.

3. The apparatus with a heat insulation structure according to claim 2, wherein
a support is connected for fixing between the internal wall of the heat insulation shell and the external wall of the object to be heat-insulated.

4. The apparatus with a heat insulation structure according to claim 3, wherein
the object to be heat-insulated is disposed inside the heat insulation shell, wherein the periphery of the object to be heat-insulated and the heat insulation shell are fixed through the support.

5. The apparatus with a heat insulation structure according to claim 3, wherein
contact area between the surface of one external wall of the object to be heat-insulated and the connected support is smaller than 50% of the area of the surface of the external wall.

6. The apparatus with a heat insulation structure according to claim 1, wherein
the heat insulation closed layer is filled with air, or there is a vacuum in the heat insulation closed layer.

7. The apparatus with a heat insulation structure according to claim 1, wherein
the object to be heat-insulated comprises one or more of the following: a battery, a temperature controlling unit, an electrolytic capacitor, a liquid crystal display, an optical module, a camera module and a crystal.
